(19) Europäisches Patentamt
European Patent Office
Office européen des brevets

(11) **EP 2 623 916 B1**

(12) **FASCICULE DE BREVET EUROPEEN**

(45) Date de publication et mention
de la délivrance du brevet:
**12.08.2015   Bulletin 2015/33**

(21) Numéro de dépôt: **13153371.3**

(22) Date de dépôt: **31.01.2013**

(51) Int Cl.:
*F28F 9/02* (2006.01)        *F16L 37/34* (2006.01)
*F16L 37/56* (2006.01)        *H05K 7/20* (2006.01)
*F28F 3/12* (2006.01)        *F28D 1/03* (2006.01)
*F28F 7/02* (2006.01)

(54) **Système de refroidissement avec conduit de circulation de fluide caloporteur**

Kühlsystem mit Kühlkreislaufleitung mit Wärmeübertragungsflüssigkeit

Cooling system with conduit for circulating a heat-transfer fluid

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:   **31.01.2012   FR 1250921**

(43) Date de publication de la demande:
**07.08.2013   Bulletin 2013/32**

(73) Titulaire: **STÄUBLI FAVERGES**
**74210 Faverges (FR)**

(72) Inventeurs:
• **Tiberghien, Alain-Christophe**
  **74320 Sevrier (FR)**
• **Durieux, Christophe**
  **73200 Gilly sur Isere (FR)**
• **Morel, Frédéric**
  **74210 Lathuile (FR)**

(74) Mandataire: **Myon, Gérard Jean-Pierre et al**
**Cabinet Lavoix**
**62, rue de Bonnel**
**69003 Lyon (FR)**

(56) Documents cités:
EP-A1- 1 790 458     EP-A2- 1 357 325
JP-A- 4 229 216     US-A- 2 463 326
US-A- 5 215 122     US-A1- 2008 245 426

**Description**

L'invention a trait à un système de refroidissement d'au moins un composant ou une pièce, dans lequel on utilise une plaque comprenant un conduit de circulation de fluide caloporteur. L'invention trouve notamment une application dans le domaine du contrôle en température de composants électroniques et dans le domaine du moulage par injection de pièces en matière synthétique, domaine dans lequel des moules doivent être refroidis.

Dans le cas d'une plaque d'échange thermique destinée à refroidir des composants électroniques, un conduit de circulation de fluide caloporteur est défini à l'intérieur de la plaque et destiné à être raccordé, par ses deux extrémités, à un conduit d'alimentation, lui-même relié à un groupe de fourniture de fluide caloporteur réfrigéré, ainsi qu'à un conduit d'évacuation de ce fluide. Lorsque le conduit de la plaque est déconnecté du conduit d'alimentation, alors que des composants électroniques encore chauds transmettent des calories au fluide caloporteur confiné dans le conduit, ce fluide caloporteur subit une élévation de température qui s'accompagne d'une augmentation de pression susceptible de causer des ruptures dans le conduit ou dans ses éléments de connexion. Des problèmes analogues se posent dans le domaine du moulage par injection où les moules sont soumis à des élévations de température, alors que leur conduit de circulation de fluide caloporteur est isolé de son alimentation.

EP-A-1 790 458 résout ces problèmes en proposant un compensateur de volume formé par un piston soumis à la pression régnant dans un conduit de circulation de fluide caloporteur et coulissant de façon étanche par rapport à la plaque. Par « compensation », on entend un ajustement du volume disponible pour le fluide confiné sous l'effet de la pression du fluide de manière à limiter ses variations de pression. Ce piston est soumis à l'action d'un ressort qui le ramène dans une position rétractée à l'intérieur de la plaque une fois que la pression du fluide caloporteur dans le conduit diminue. Cette solution donne globalement satisfaction, notamment dans la mesure où aucune action de l'opérateur n'est requise sur le dispositif de compensation lors des déconnexions/reconnexions successives de la plaque avec les conduits d'alimentation et d'évacuation correspondants. En outre, la compensation de volume a lieu sans fuite de liquide caloporteur. Toutefois, pour être efficace, ce matériel impose une excellente maîtrise de l'effort de rappel élastique exercé par le ressort et des efforts de frottement du piston à l'intérieur du corps dans lequel il coulisse. Ce ressort doit combattre ces efforts de frottement, alors que la force de pression qui déplace le piston doit vaincre l'effort élastique dû au ressort. Ce dispositif de compensation est donc peu sensible aux faibles variations de pression. En outre, en cas de défaillance du ressort, ce dispositif n'est pas en mesure de garantir qu'un volume d'expansion suffisant est disponible pour le fluide caloporteur.

C'est à ces inconvénients qu'entend plus particulièrement remédier l'invention en proposant un nouveau système de refroidissement dans lequel une compensation de volume peut être obtenue pour tenir compte d'une augmentation de pression dans le conduit d'une plaque d'échange thermique, sans qu'il soit nécessaire d'avoir recours à un ressort agissant sur un piston et sans qu'il soit nécessaire d'armer le système par une manoeuvre annexe lors de chaque déconnexion/reconnexion de la plaque avec les conduits d'alimentation et d'évacuation associés.

A cet effet, l'invention concerne un système de refroidissement d'au moins un composant ou une pièce, ce système comprenant une plaque d'échange thermique qui comprend un conduit de circulation de fluide caloporteur et qui est équipée, d'une part, en extrémités d'éléments de raccord pourvus chacun d'un obturateur et, d'autre part, d'un dispositif de compensation de volume comprenant un piston monté avec possibilité de coulissement étanche par rapport à la plaque, entre une première position rétractée et une deuxième position avancée par rapport à la position rétractée et dans laquelle le volume disponible pour le fluide caloporteur dans le conduit est augmenté par rapport à son volume dans la première position. Ce système comprend également des moyens d'alimentation et/ou d'évacuation du conduit en fluide caloporteur, ces moyens comprenant des éléments de raccord complémentaires de ceux de la plaque pour le raccordement et la déconnexion du conduit de la plaque avec une source d'alimentation et/ou une ligne d'évaluation de fluide caloporteur. Conformément à l'invention, un organe de maintien du piston dans sa position rétractée est solidaire d'au moins un premier élément de raccord complémentaire d'un premier élément de raccord de la plaque, au moins en translation selon leur axe d'emmanchement. En outre, cet organe de maintien est apte à bloquer le piston dans sa première position lorsque le premier élément de raccord de la plaque et le premier élément de raccord complémentaire sont accouplés et à maintenir le piston dans sa première position, lors du désaccouplement du premier élément de raccord de la plaque et du premier élément de raccord complémentaire, au moins tant que l'obturateur du premier élément de raccord de la plaque n'est pas en position d'obturation d'un conduit interne de cet élément de raccord.

Grâce à l'invention, l'organe de maintien assure que, lors de la manoeuvre de désaccouplement ou de déconnexion des éléments de raccord, le piston du dispositif de compensation est positionné dans sa première position rétractée à l'obturation du conduit de circulation de manière à garantir le volume disponible pour la compensation de volume lorsque les éléments de raccord ont été désaccouplés.

Selon des aspects avantageux mais non obligatoires de l'invention, un tel système de refroidissement peut incorporer une ou plusieurs des caractéristiques suivantes prises dans toute combinaison techniquement admissible :

- Un axe de coulissement du piston entre ses première et deuxième positions est parallèle à un axe d'emmanchement du premier élément de raccord de la plaque et du premier élément de raccord complémentaire.
- L'organe de maintien est apte à agir sur au moins un organe de blocage du piston dans sa première position rétractée.
- L'organe de maintien est apte à venir en recouvrement de l'organe de blocage pour le blocage du piston dans sa première position rétractée.
- L'organe de blocage est mobile radialement par rapport à un axe de coulissement du piston, entre une première position de blocage du piston dans sa première position rétractée et une deuxième position de libération du piston.
- Selon un axe de coulissement du piston, dans sa première position, l'organe de blocage solidarise en translation le piston avec un corps du piston, lui-même fixe en translation par rapport à la plaque.
- L'organe de blocage est solidaire en translation du piston du dispositif de compensation de volume selon un axe de coulissement du piston.
- Le piston est pourvu d'un logement de réception partielle de l'organe de blocage uniquement dans sa première position rétractée.
- Le système comporte plusieurs organes de blocage répartis autour d'un axe central de coulissement du piston.
- L'organe de maintien comprend un corps principal fixe en translation par rapport à un corps du premier élément de raccord complémentaire, ainsi qu'un corps secondaire mobile en translation par rapport au corps principal fixe, selon une direction parallèle à un axe d'emmanchement du premier élément de raccord de la plaque et du premier élément de raccord complémentaire alors que le corps secondaire est repoussé élastiquement vers l'avant par rapport au corps principal fixe et que le corps secondaire et/ou le corps principal sont aptes à venir en butée contre le piston au moins en configuration accouplée des éléments de raccord.
- Le corps secondaire est apte à agir sur au moins un organe de blocage du piston dans sa première position.
- Le corps principal est pourvu d'une partie d'appui contre le piston en configuration accouplée du premier élément de raccord de la plaque et du premier élément de raccord complémentaire, alors que le corps principal est positionné par rapport au premier élément de raccord complémentaire de telle sorte que, lors de l'accouplement de cet élément de raccord avec le premier élément de raccord de la plaque, le premier élément du raccord de la plaque et le premier élément de raccord complémentaire sont amenés en configuration passante, avant que la partie d'appui du corps principal entre en contact avec le piston.

- En configuration accouplée du premier élément de raccord de la plaque et du premier élément de raccord complémentaire, la somme de la longueur de recouvrement sur laquelle l'organe de maintien reste en prise avec l'organe de blocage, mesurée parallèlement à un axe d'emmanchement de ces éléments de raccord, et d'un jeu axial entre le corps principal et le corps secondaire est supérieure à la course de fermeture de l'obturateur du premier élément de raccord de la plaque à partir de la configuration accouplée et parallèlement à l'axe d'emmanchement des éléments de raccord.
- L'organe de maintien est également solidaire d'un second élément de raccord complémentaire d'un second élément de raccord de la plaque, au moins en translation selon leur axe d'emmanchement, alors que cet organe de maintien est apte à maintenir le piston dans sa première position, lors du désaccouplement des premiers éléments des raccords de la plaque et des premiers éléments des raccords complémentaires, au moins tant que chacun des obturateurs des premiers éléments de raccord de la plaque n'est pas en position d'obturation du conduit interne respectif des éléments de raccord.

L'invention sera mieux comprise et d'autres avantages de celle-ci apparaîtront plus clairement à la lumière de la description qui va suivre de deux modes de réalisation d'un système conforme à son principe, donnée uniquement à titre d'exemple et faite en référence aux dessins annexés dans lesquels :

- la figure 1 est une représentation schématique de principe d'un système de refroidissement de composants électroniques conforme à l'invention,
- la figure 2 est une vue à plus grande échelle du détail II à la figure 1,
- la figure 3 est une vue analogue à la figure 2 lorsqu'un piston du système de la figure 1 est dans une autre position,
- la figure 4 est une vue à plus grande échelle correspondant au détail IV à la figure 1 lors de l'accouplement des éléments de raccord représentés en partie supérieure de cette figure à partir d'une configuration où le piston est dans la configuration de la figure 3,
- la figure 5 est une vue analogue à la figure 4 en configuration connectée des éléments de raccord visibles sur cette figure,
- la figure 6 est une vue analogue à la figure 5 lors de la déconnexion des éléments de raccord visibles sur cette figure et
- la figure 7 est une vue comparable au détail VII à la figure 5 pour un système conforme à un deuxième mode de réalisation de l'invention.

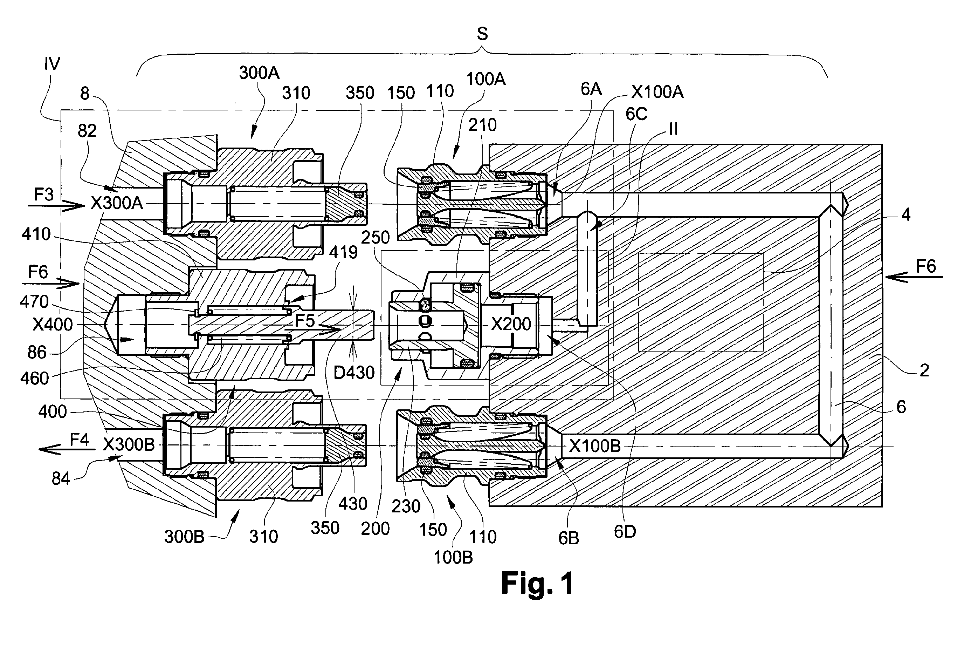

A la figure 1, une plaque d'échange thermique 2 est utilisée pour refroidir un composant électronique 4 de type transistor bipolaire à grille isolée ou IGBT ou tout autre composant qui s'échauffe en cours de fonctionnement. Un conduit 6 de circulation de fluide caloporteur, tel que de l'eau ou de l'huile, est ménagé dans la plaque 2 et s'étend entre une première extrémité 6A et une deuxième extrémité 6B au niveau de chacune desquelles est respectivement monté un élément de raccord 100A ou 100B.

Ces éléments de raccord 100A et 100B sont identiques et comportent chacun un corps 110 vissé dans un orifice taraudé correspondant de la plaque 2 avec interposition d'un joint d'étanchéité 120. Chaque corps 110 est creux et définit un alésage central 130 dans lequel est disposé un poussoir 140 fixe par rapport au corps 110. L'alésage central 130 constitue le conduit interne de l'élément de raccord 100A. Un obturateur ou soupape 150 est monté dans l'alésage 130 et soumis à l'action d'un ressort 160 de rappel élastique de l'obturateur 150 contre un siège 112 formé par le corps 110. Deux joints 152 et 154 sont respectivement montés dans des gorges périphériques du corps 110 et du poussoir 140 et assurent l'étanchéité de la fermeture de l'élément 100A ou 100B en configuration plaquée de l'obturateur 150 contre son siège 112. Chaque élément de raccord est centré sur un axe X100A, respectivement X100B, parallèlement auquel se déplace son obturateur 150 par rapport à son corps 110.

Le conduit 6 comprend également une branche 6C qui constitue une dérivation par rapport à la partie du conduit s'étendant entre les extrémités 6A et 6B et dont on note 6D l'extrémité opposée à la partie du conduit s'étendant entre les extrémités 6A et 6B. Sur cette extrémité 6D est monté un dispositif de compensation de volume 200 qui comprend un corps 210 dont une extrémité taraudée est solidarisée à la plaque 2 par vissage dans un logement correspondant de la plaque 2, avec interposition d'un joint d'étanchéité 220. Le corps 210 est creux et définit un alésage central 212 qui est étagé et à l'intérieur duquel est monté un piston 230 coulissant selon un axe X200 défini par le corps 210. L'axe X200 est un axe central de symétrie circulaire du corps 210 et du piston 230.

Les axes X100A, X100B et X200 sont parallèles.

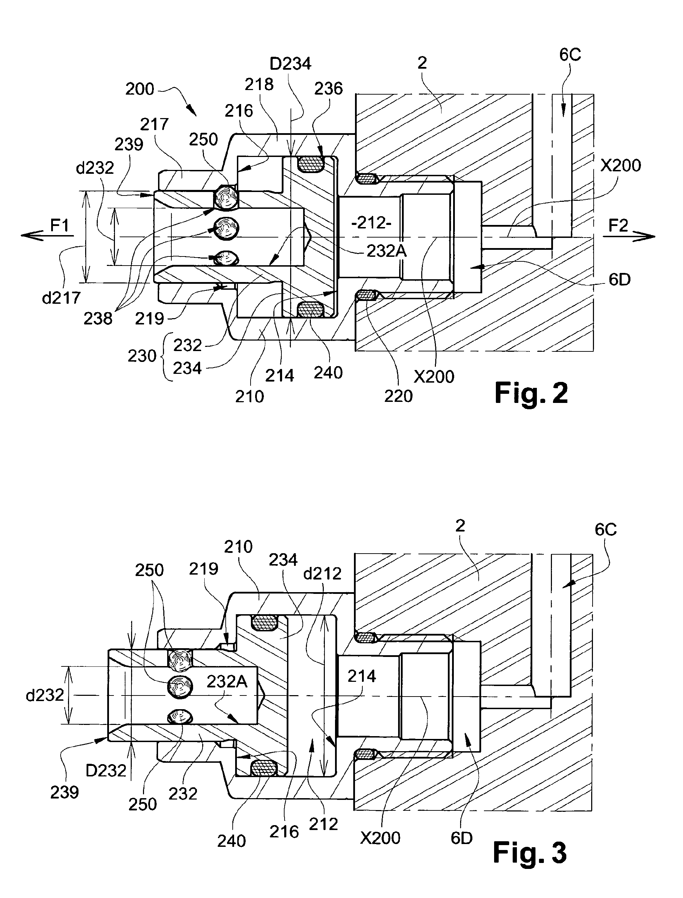

Le piston 230 comprend une portion 232, qui est creuse et dont on note D232 le diamètre extérieur et d232 le diamètre intérieur, ainsi qu'une portion élargie 234 pleine qui obture la portion 232. La portion 232 est donc tubulaire, borgne et à section circulaire. La portion 234 est également circulaire et l'on note D234 son diamètre extérieur qui est légèrement inférieur au diamètre interne maximal d212 de l'alésage 212, dans sa partie dans laquelle est logée la portion 234. La portion 234 est pourvue d'une gorge périphérique externe 236 dans laquelle est logé un joint 240 comprimé contre la surface radiale interne du corps 210 dans sa partie de plus grand diamètre interne d212. Ainsi, le piston 230 est monté avec possibilité de coulissement étanche à l'intérieur du corps 210, entre les positions respectivement représentées aux figures 2 et 3.

On définit l'avant du dispositif 200 comme étant orienté à l'opposé de la plaque 2, alors que l'arrière de ce dispositif est orienté vers la plaque 2. Ainsi, la flèche F1 à la figure 2 est orientée de l'arrière vers l'avant du dispositif 200, alors que la flèche F2 est orientée de l'avant vers l'arrière.

A la figure 2, le piston 230 est dans une position rétractée dans le corps 210 dans laquelle sa portion 234 est à proximité d'un épaulement arrière 214 défini par le corps 210. A la figure 3, le piston 230 est dans une position avancée par rapport à la position de la figure 2 dans laquelle sa portion 234 est à proximité d'un épaulement avant 216 défini par le corps 210.

La portion 232 est percée, radialement par rapport à l'axe X200, de huit orifices 238 régulièrement répartis autour de cet axe et dans chacun desquels est logée une bille 250.

Par ailleurs, le corps 210 comprend une portion avant 217 qui est circulaire et dont le diamètre intérieur d217 est légèrement supérieur au diamètre D232, de telle sorte que la portion 217 constitue une partie de guidage en translation de la portion 232 du piston 230. On note par ailleurs 218 la portion du corps 210 dont le diamètre intérieur d212 est le diamètre maximal de l'alésage 212 et qui accueille la portion 234 du piston 230. A l'intérieur du corps 210, et à la jonction entre les portions 217 et 218, un logement annulaire 219 est prévu sous la forme d'une portion de diamètre élargi par rapport au diamètre d217. Ce logement 219 permet de recevoir partiellement les billes 250 engagées dans les orifices 238, lorsque ces billes ne dépassent pas radialement vers l'axe X200 à partir de la surface radiale interne 232A de la portion 232.

Lorsque les billes sont maintenues dans le logement 219, elles bloquent le déplacement en translation du piston 230 vers l'avant, c'est-à-dire dans le sens de la flèche F1. A contrario, lorsque les billes peuvent librement dépasser radialement vers l'intérieur, à partir de la surface 232A, elles ne s'opposent pas à une translation du piston 230 vers l'avant, à partir de sa position de la figure 2. A cet égard, le diamètre des orifices 238 à proximité de la surface 232A est légèrement inférieur à celui des billes 250 pour éviter que ces billes passent complètement dans le volume intérieur de la portion 232.

Lorsque la plaque 2, les éléments de raccord 100A et 100B et le dispositif de compensation 200 sont dans la configuration des figures 1 et 2, c'est-à-dire lorsque le conduit 6 est isolé de l'extérieur par les obturateurs 150 avec les éléments de raccord 100A et 100B désaccouplés des éléments de raccord 300A et 300B, en cas d'augmentation de température du fluide caloporteur dans le conduit 6, notamment du fait de la transmission de calories par le composant 4, la montée en pression du fluide caloporteur se traduit par une augmentation de pression y compris au niveau de l'extrémité 6D de la branche 6C. Ceci qui a pour effet d'exercer un effort sur la surface arrière de la portion 234 qui déplace le piston 230 vers l'avant, dans le sens de la flèche F1 à la figure 2. Ce mouvement d'avancée du piston 230 est possible car le volume intérieur de la portion 232 en regard des billes 250 est inoccupé et les billes 250 peuvent être chassées du logement 219 et dépasser radialement vers l'intérieur par rapport à la surface 232A. Le piston 230 passe alors de la configuration de la figure 2 à la configuration de la figure 3 ou à une configuration intermédiaire entre ces figures, en augmentant, par rapport à la configuration du piston 230 en position rétractée, le volume disponible dans l'alésage 212 et donc dans le conduit 6 pour le fluide caloporteur présent dans la plaque 2, limitant ainsi son élévation de pression. En position avancée du piston 230, le fluide occupe en effet une partie du volume de l'alésage 212 disposé au niveau de la portion 218 de diamètre maximal d212, partie disposée en arrière de la partie 234 du piston. L'amplitude de la course potentielle du piston 130 est déterminée de telle sorte que la pression du fluide confiné dans le conduit 6 reste en-deçà d'une valeur de pression pour laquelle la plaque 2 et ses composants pourraient être altérés. Dans ce mode de réalisation, l'amplitude de la course potentielle du piston 130 est de l'ordre de 15 mm pour un diamètre d212 de l'ordre de 50 mm. Ce mouvement du piston 230, sous l'effet de la différence de pression entre le conduit 6 et l'extérieur de la plaque 2, a lieu sans fuite au niveau du dispositif de compensation 200 grâce à l'étanchéité assurée par le joint 240 entre la surface radiale interne du corps 210 au niveau de sa portion 218 et la surface radiale externe du piston 230 au niveau de sa portion élargie 234.

Le système S de l'invention comprend non seulement la plaque 2 mais également une plaque de raccordement 8 à l'intérieur de laquelle sont définis deux conduits 82 et 84 servant respectivement à alimenter le conduit 6 en fluide caloporteur réfrigéré et à évacuer ce fluide caloporteur à partir du conduit 6. Le conduit 82 est connecté à une source non représentée de liquide caloporteur réfrigéré et le conduit 84 est connecté à une ligne d'évacuation du fluide caloporteur vers une unité de traitement, également non représentée. A la figure 1, les flèches F3 et F4 représentent le sens d'écoulement du fluide caloporteur dans les conduits 82 et 84 lorsque ceux-ci sont raccordés au conduit 6. Aux extrémités des conduits 82 et 84 dirigés vers la plaque 2, sont respectivement montés deux éléments de raccord 300A et 300B complémentaires des éléments 100A et 100B. Ces éléments de raccord 300A et 300B sont identiques et comprennent chacun un corps 310 dont une partie filetée est vissée dans un taraudage correspondant de la plaque 8, avec interposition d'un joint d'étanchéité 320. L'alésage central 330 de chaque corps 310 est fermé par défaut par un obturateur 350 soumis à l'action d'un ressort de rappel élastique 360. Un joint d'étanchéité 352 est monté sur l'obturateur 350 et assure l'étanchéité entre l'alésage 330 et l'extérieur de l'élément de raccord lorsque l'obturateur 350 est en appui contre un siège 312 défini par le corps 310. On note 340 une partie tubulaire du corps 310 à l'intérieur de laquelle est logé l'obturateur 350 en position fermée et qui délimite le siège 312. Cette partie tubulaire 340 s'étend en saillie du reste du corps 310, à l'opposé du conduit 82 ou 84 sur lequel est monté l'élément de raccord complémentaire 300A ou 300B. Lors de la connexion des éléments de raccord 100A et 300A ou 100B et 300B, la partie 340 sert de poussoir pour déplacer l'obturateur 150 à l'encontre de l'action du ressort 160.

La plaque 8 porte également un organe de maintien 400 destiné à agir sur le piston 230 du dispositif 200. Cet organe 400 comprend un corps principal 410 dont une partie filetée est vissée dans un taraudage borgne 86 de la plaque 8. Le corps principal supporte un doigt 430, qui est monté sur le corps principal 410 et qui constitue un corps secondaire mobile en translation selon un axe X400 parallèle aux axes longitudinaux respectifs X300A et X300B des éléments de raccord complémentaire 300A et 300B, le long desquels se déplacent les obturateurs 350. L'organe de maintien 400 est solidaire de la plaque 8 selon l'axe X400 dans le sens où ses configurations dépendent de la position axiale selon l'axe X400 de la plaque 8 par rapport à la plaque 2. Un ressort 460 exerce sur le doigt 430 un effort élastique qui tend à pousser ce doigt à l'opposé du fond du taraudage 86, dans le sens de la flèche F5 à la figure 1. Le déplacement du doigt 430 sous l'action du ressort 460 est limité par un circlip 470 monté sur une extrémité 432 du doigt 430 tournée vers le fond de l'alésage 86 et qui vient en appui contre un épaulement 412 du corps principal 410.

Pour les éléments 300A, 300B et 400, on définit le côté arrière comme le côté tourné vers la plaque 8, c'est-à-dire respectivement vers les conduits 82 et 84 et vers le fond de l'alésage 86, et l'avant de ces éléments comme tourné à l'opposé de la plaque 8. Ainsi, les ressorts 360 et 460 poussent par défaut les obturateurs 350 et le doigt 430 vers l'avant par rapport aux corps 310 et 410.

Les corps 110, 210, 310 et 410 sont rigidement montés, respectivement sur les plaques 2 et 8, de telle sorte qu'il est possible d'aligner simultanément les axes X100A et X300A, les axes X100B et X300B et les axes X200 et X400. Ceci est possible en utilisant le même écartement entre les axes X100A, X100B et X200, sur la plaque 2, et les axes X300A, X300B et X400, sur la plaque 8.

Ainsi, il est possible, en agissant sur les plaques 2 et 8, d'exercer un effort de rapprochement des éléments de raccord 100A et 300A, d'une part, 100B et 300B, d'autre part, et d'amener en contact le doigt 430 et le piston 230. Lorsqu'il convient de connecter les conduits 82 et 84 avec le conduit 6 à partir de la configuration des figures 1 et 2, les axes X100A, X300A, X100B, X300B, X200 et X400 sont respectivement alignés et un effort de rapprochement est exercé, dans le sens des flèches F6 à la figure 1. Les axes X100A et X300A, qui sont alors confondus, constituent des axes d'emmanchement des éléments 100A et 100B. Il en va de même pour les axes X100 B et X300B et les éléments 100B et 300B. Ce mouvement a pour effet d'amener en prise les éléments de raccord 100A et 100B de la plaque 2 respectivement avec les éléments de raccord 300A et 300B de la plaque 8, en écartant les obturateurs 150 et 350 de leurs sièges respectifs, ce qui permet d'établir une circulation de fluide caloporteur entre le conduit 6 et les conduits 82 et 84.

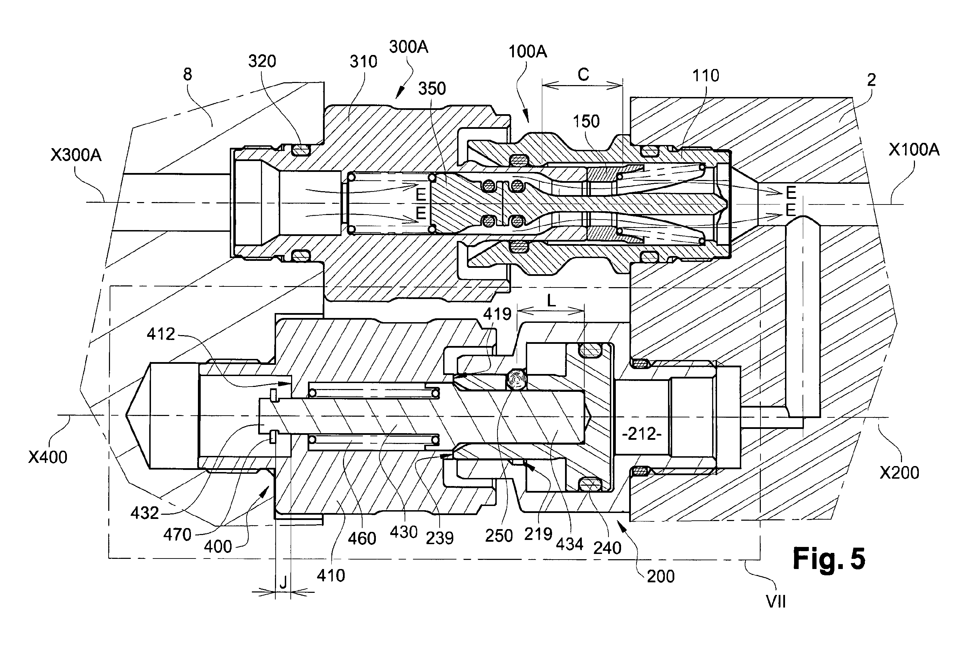

Lorsque le piston 230 est dans la position de la figure 2 au début du rapprochement des plaques 2 et 8, le mouvement de rapprochement a également pour effet d'engager le doigt 430 dans le volume intérieur de la portion 232 du piston 230, ce qui est possible car le diamètre extérieur D430 de la partie avant 434 du doigt 430 est légèrement inférieur au diamètre d232. L'introduction du doigt 430 dans le volume intérieur de la portion 232 jusqu'à ce qu'il vienne en butée contre le fond du volume intérieur de la portion 232 est possible du fait que les billes 250 peuvent être chassées radialement vers l'extérieur, dans le logement 219, comme représenté à la figure 5. Parallèlement les deux éléments de raccord 100A et 300A sont accouplés de manière étanche, sans fuite.

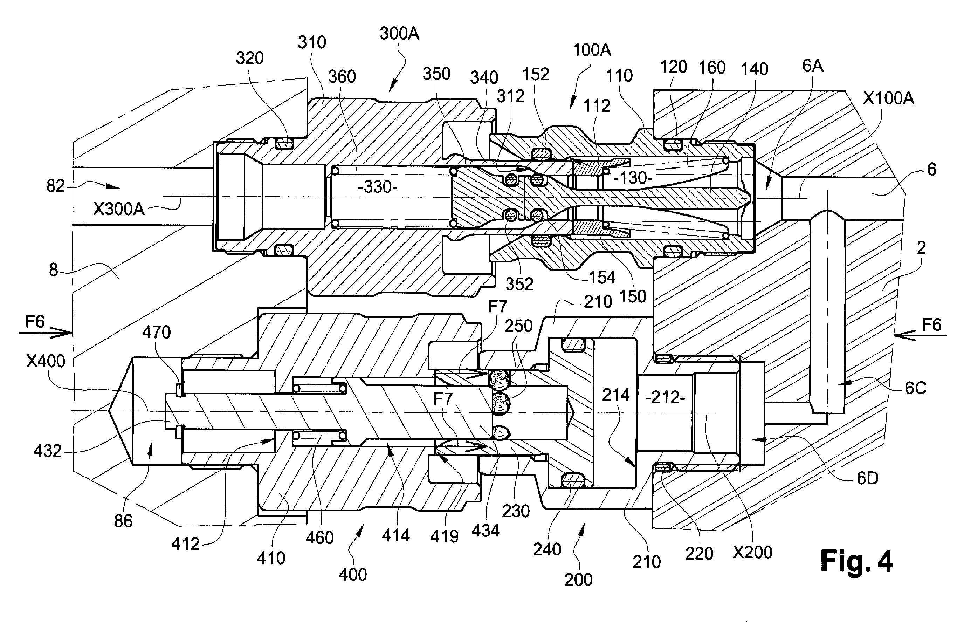

Lorsque le piston 230 a été déplacé vers l'avant pour assurer une fonction de compensation de volume comme expliqué ci-dessus, et en cas de rapprochement des plaques 2 et 8 pour procéder à une connexion des éléments de raccord 100A et 100B respectivement avec les éléments de raccord 300A et 300B, ce rapprochement met en contact les obturateurs des éléments de raccord avec les poussoirs correspondants alors que le doigt 430, qui s'engage dans le piston 230, vient buter, par sa partie avant 434 contre les billes 250 qui font saillie radialement vers l'axe X200 à partir de la surface 232A. Tant que les éléments de raccord 100A, 100B, 300A et 300B ne sont pas passants, c'est-à-dire tant que les obturateurs 150 et 350 ne sont pas dégagés de leurs sièges respectifs, la pression dans le conduit 6 maintient le piston 230 en position avancée, c'est-à-dire dans la position de la figure 3 ou dans une position intermédiaire entre celles des figures 2 et 3. Le doigt 430 ne peut donc pas progresser vers la portion 234 du piston 230 car il est bloqué par les billes 250 maintenues radialement vers l'intérieur par rapport à la surface 232A par la surface interne de la portion avant 217. Le mouvement de rapprochement des plaques 2 et 8 demeure possible car le doigt 430 peut coulisser dans le logement correspondant 414 ménagé à cet effet dans le corps principal 410, à l'encontre de l'action du ressort 460. En d'autres termes, le montage coulissant du doigt 430 sur le corps principal 410 permet le recul du doigt dans son logement pour atteindre la configuration de la figure 4 où les obturateurs 150 et 350 parviennent en position passante, sans générer de fuite avec la partie tubulaire 340 qui vient au contact du joint 152, alors que le piston 230 demeure en position avancée, ce qui permet d'établir un écoulement de fluide caloporteur représenté par les flèches E. Ceci permet d'équilibrer la pression de fluide caloporteur entre le conduit 6 et les conduits 82 et 84 et de diminuer la pression dans la partie de l'alésage intérieur 212 du corps 210 qui est reliée fluidiquement à la branche 6C du conduit 6.

Dans cette configuration, le bord avant 239 du piston 230, c'est-à-dire de son bord opposé à l'extrémité 6D de la branche 6C, est au contact d'une surface d'appui annulaire 419 du corps 410 qui entoure le logement 414 dans lequel coulisse le doigt 430. La surface 419 exerce alors, lors de la poursuite du mouvement de rapprochement des plaques 2 et 8 dans le sens des flèches F6, un effort représenté par les flèches F7 à la figure 4 qui repousse le piston 230 vers l'épaulement arrière 214 pour le ramener dans sa position rétractée de la figure 2. Le déplacement du piston 230 à l'intérieur du corps 210 est possible du fait de la diminution de pression dans le conduit 6 suite à l'ouverture du raccord formé des éléments 100B et 300B. Lors de ce déplacement, le doigt 230 demeure en appui contre les billes 250 puisqu'il est soumis à l'action du ressort 460. En d'autres termes, le doigt 430 accompagne le mouvement de rétraction du piston 230 à l'intérieur du corps 210. Lorsque le piston 230 parvient dans sa position rétractée de la figure 2, les billes 250 sont radialement en regard du logement 219 et l'effort exercé par le ressort 460 sur le doigt 430, effort qui tend à pousser le doigt 430 vers la portion 234 du piston 230, repousse radialement les billes 250 vers le logement 219. En d'autres termes, le doigt 430 s'engage radialement entre les billes 250 qu'il renvoie vers le logement 219, dans une configuration où ces billes bloquent le piston 250 dans sa position rétractée des figures 1 et 2, c'est-à-dire empêche le mouvement du piston 250 vers l'avant. Le ressort 460 pousse alors le doigt 430 jusqu'à la configuration de la figure 5 où la partie avant 434 du doigt 430 est en appui contre le fond du logement creux central de la portion 232.

Les éléments de raccord 100A, 100B et 300A, 300B atteignent leur position accouplée lorsque les plaques 2 et 8 atteignent une position de connexion, dans laquelle elles sont maintenues. Dans cette position connectée des plaques, un jeu axial J demeure entre le circlip 470 et l'épaulement 412. Dans cette position, le doigt 430 recouvre les billes 250 et les maintient engagées dans le logement 219, ce qui solidarise en translation le piston 230 avec le corps 210 selon l'axe X200 et le bloque en position rétractée dans le corps 210. Le piston 230 est également maintenu en position rétractée par l'épaulement 419 en contact avec le piston 230. Ainsi, le corps 410 et le piston 430 viennent en butée contre le piston 230 en configuration accouplée. En variante, seul un de ces éléments est en butée contre le piston 230 dans cette configuration.

Dans cette configuration connectée représentée à la figure 5, les éléments de raccord 100A et 300A, d'une part 100B et 300B, d'autre part sont raccordés et passants. Dans cette position, l'obturateur 150 de l'élément de raccord 100A est décalé, le long de l'axe X100A, par rapport à sa position d'obturation de l'alésage 130. Ce décalage, pris axialement entre l'obturateur 150 et son siège 112, correspond à la course de fermeture C de l'obturateur 150 à partir de cette configuration de la figure 5. La course de fermeture de l'obturateur 150 de l'élément de raccord 100B est également égale à la course de fermeture C car les éléments de raccord 100A, 100B sont identiques.

Dans cette configuration également, le doigt 430 est en butée contre le piston 230 et engagé, à l'intérieur du piston 230 et au-delà des centres des billes 250, sur une longueur L qui correspond à la longueur de recouvrement entre le doigt 430 et les billes 250 sur laquelle le doigt 430 reste en prise avec les billes 250 alors qu'il est reculé, à l'opposé de la plaque 2, à partir de la configuration accouplée. La somme de la distance L et du jeu J est supérieure ou égale à la course C. En d'autres termes, la relation suivante est vérifiée :

$$L + J \geq C$$

Si les éléments de raccord 100A et 100B n'étaient pas identiques, il conviendrait de vérifier que la somme de la distance L et du jeu J est supérieure ou égale à la plus grande des courses C prises respectivement au niveau de l'élément de raccord 100A et au niveau de l'élément de raccord 100B.

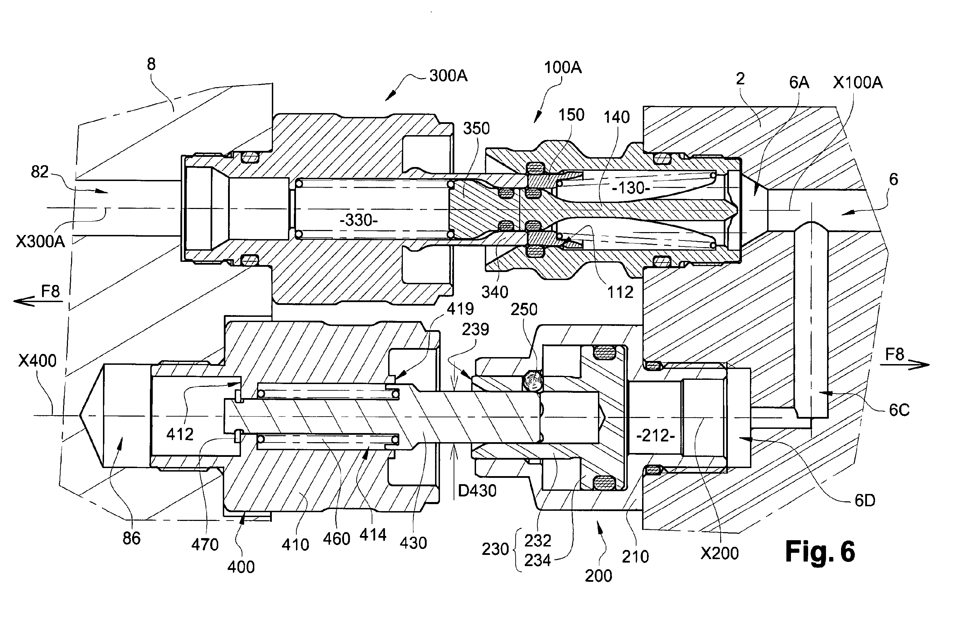

Lorsqu'il convient d'isoler le conduit 6 des conduits 82 et 84, l'opérateur place les conduits 6, 82 et 84 « hors pression », c'est-à-dire à l'atmosphère, et les plaques 2 et 8 sont écartées l'une de l'autre comme représenté par les flèches F8 à la figure 6. Ceci a pour effet de séparer les éléments 100A et 300A, d'une part, 100B et 300B, d'autre part, de sorte que les obturateurs 150 et 350 sont repoussés par les ressorts 160 et 360 vers leur configuration de fermeture des alésages 130 et 330.

Lors de ce mouvement d'écartement, le doigt 430 reste en butée contre le piston 230 jusqu'à ce qu'il parvienne en butée contre l'épaulement 412 puis le doigt 430 suit le mouvement de la plaque 8 et est progressivement retiré du volume intérieur du piston 430. Comme montré à la figure 6, dans la mesure où la somme de la longueur L et du jeu J est supérieure à la course C, le doigt 430 demeure engagé radialement entre les billes 250 et agit sur les billes 250 au moins jusqu'à ce que l'obturateur 150 de l'élément de raccord 100A et l'obturateur de l'élément de raccord 100B parviennent en configuration de fermeture étanche des alésages 130 respectifs. Il est ainsi garanti que le piston 230 est bloqué par les billes 250 dans sa configuration rétractée au moins tant que chacun des obturateurs 150 n'est pas en position d'obturation de l'alésage 130 associé et donc tant que le conduit 6 n'est pas isolé des conduits 82 et 84. La poursuite du mouvement d'écartement des plaques 2 et 8, à partir de la configuration de la figure 6 jusqu'à la configuration désaccouplée des raccords et des plaques, a pour effet de finir de ramener les obturateurs 150 et 350 vers leur position de la figure 1 et d'extraire le doigt 430 du piston 230. Le doigt 430 n'agit donc plus sur les billes 250 et le piston est donc libéré en configuration désaccouplée des raccords et des plaques.

On est alors dans la configuration de la figure 1 où, en fonction d'une augmentation de pression dans le conduit 6, le piston 230 peut passer de sa position rétractée à une position avancée, en augmentant le volume disponible pour le fluide caloporteur contenu dans la plaque 2.

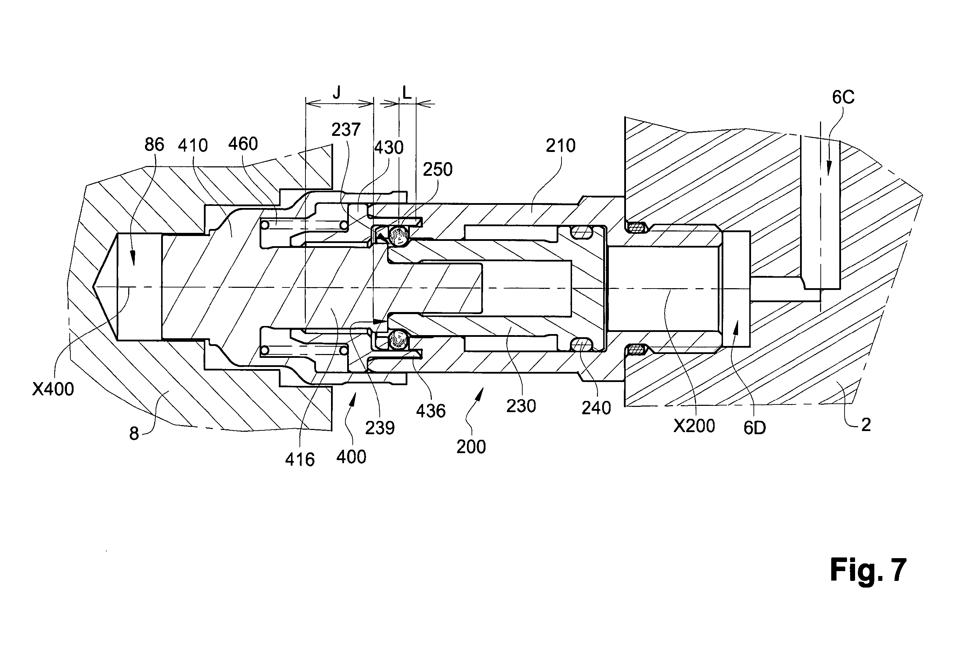

Dans le deuxième mode de réalisation représenté à la figure 7, les éléments analogues à ceux du premier mode de réalisation portent les mêmes références. Dans ce qui suit, on ne décrit que ce qui distingue ce mode de réalisation du précédent.

Dans ce mode de réalisation, les billes 250, mobiles radialement dans des logements ménagés dans le corps 210, sont solidaires en translation du corps 210 selon l'axe X200 et le logement de réception des billes de blocage 250 n'est pas prévu sur l'intérieur du corps 210 du dispositif de compensation de volume 200 mais sur l'extérieur du piston 230, au voisinage de son bord avant 239. Sur la figure 7, ce logement porte la référence 237 et les billes 250 y sont radialement engagées, sous l'action d'une bague de maintien 430 porté par l'organe de maintien 400 et dont une jupe 436 entoure radialement les billes 250 pour les recouvrir dans la configuration connectée représentée à la figure 7. Les billes 250 bloquent alors le piston en position rétractée. La bague de maintien 430 est soumise à l'action d'un ressort 460 et guidée autour d'une partie centrale 416 d'un corps principal 410 de l'organe de maintien 400. En configuration obturée du conduit 6, dès que le piston 230, sous l'effet de la pression, coulisse vers sa position avancée, les billes 250 s'extraient du logement 237. Ainsi, le mouvement des billes 250 entre leur position de blocage du piston 230 en position rétractée et leur position de libération du piston est un mouvement radial et centrifuge, alors que ce mouvement est un mouvement radial et centripète dans le mode de réalisation des figures 1 à 6. Pour le reste, ce mode de réalisation fonctionne globalement comme le premier mode de réalisation, avec les mêmes avantages. On définit pour ce mode de réalisation la distance L et le jeu J comme dans le premier mode de réalisation. La distance L est la distance sur laquelle la jupe 436 de l'organe de maintien 400 reste en prise avec les billes 250 lors du désaccouplement. Le jeu J est le jeu entre la bague 430 et sa butée avant sur le corps 410 dans la position accouplée de la figure 7. La course C n'est pas visible sur cette figure mais correspond à celle repérée sur la figure 5. Comme dans le premier mode de réalisation, la relation suivante est vérifiée :

$$L + J \geq C$$

Quel que soit le mode de réalisation, le dispositif de compensation 200 de l'invention est actionné grâce à des mouvements uniquement axiaux de rapprochement et d'éloignement des plaques 2 et 8, sans nécessiter de mouvement de rotation tel qu'utilisé classiquement dans les systèmes à baïonnette. Ceci permet d'envisager un raccordement des plaques 2 et 8 par des mouvements de translation uniquement, notamment au moyen de vérins.

La compensation au sein du dispositif 200 a lieu de façon étanche et sans fuite, y compris après un grand nombre de connexions/déconnexions des éléments de raccord 100A et 300A, d'une part, 100B et 300B, d'autre part.

Le maintien du piston 230 en position rétractée jusqu'à la fermeture de l'élément de raccord 100A est assuré par les billes 250 et le doigt 430 du premier mode de réalisation ou la bague 430 du deuxième mode de réalisation. Il n'est pas nécessaire d'utiliser un ressort de rappel qui agirait directement sur le piston 230, ce qui évite les problèmes mentionnés ci-dessus au sujet de EP-A-1 790 458. L'utilisation d'organes de blocage mobile radialement, tels que les billes 250, permet de limiter les efforts axiaux à exercer sur le doigt 430 pour bloquer le piston 230 en position rétractée.

En outre, le maintien du piston 230 dans sa position rétractée et sa libération lors du passage en position désaccouplée des éléments de raccord 100A et 300A, 100B et 300B sont obtenus de façon automatique par la cinématique de désaccouplement des plaques. L'opérateur n'a pas à intervenir sur le dispositif de compensation de volume 200 pour l'armer après déconnexion des plaques.

La cinématique d'accouplement, par un rapprochement dans le sens des flèches F6, garantit le recul du piston 230 vers sa position rétractée lorsque celui-ci est dans une position avancée au début de l'accouplement. Là encore, l'opérateur n'a pas à agir sur le dispositif de compensation de volume 200 avant de raccorder le conduit 6 aux conduits 82 et 84. En particulier, le recul du piston 230 vers sa position rétractée est assuré par l'effort de rapprochement des plaques qui est transmis par le corps principal de l'organe 400 sous la forme de l'effort F7, ce qui est bien supérieur à l'effort que l'on pourrait obtenir au moyen d'un ressort agissant directement sur le piston 230.

Selon des variantes de l'invention, on peut envisager des organes de blocage autres que des billes, par exemple un ou plusieurs verrous transversaux bloqués par une bague mobile longitudinalement le long du dispositif de compensation 200. En variante, des doigts de verrouillage mobiles selon un axe transversal incliné par rapport à la direction radiale peuvent être utilisés, ces doigts de verrouillage étant recouverts et manoeuvrés grâce à une bague extérieure au dispositif de compensation.

L'invention est représentée sur les figures dans le cas où les deux éléments de raccord 300A et 300B sont portés par la même plaque 8 qui porte également l'organe de maintien 400. En variante, le système S de l'invention peut comprendre un organe de maintien 400 solidarisé à un support sur lequel est monté un seul élément de raccord complémentaire, par exemple l'élément de raccord complémentaire 300A sur les figures. Dans ce cas, c'est le raccordement des éléments de raccord 100A et 300A qui permet d'agir sur le dispositif de compensation 200 grâce à l'organe de maintien 400. Lors du désaccouplement, l'organe de maintien 400 maintient le piston 230 en position rétractée tant que la soupape 150 de l'élément de raccord 100A n'est pas en position d'obturation de l'alésage 130 de l'élément de raccord 100A. De ce cas, l'opérateur procède préférentiellement au désaccouplement des deux éléments de raccord 100B et 300B avant le désaccouplement des éléments de raccord 100A et 300A.

Les éléments 2 et 8 mentionnés dans la description ci-dessus sont qualifiés de « plaques » en utilisant le vocabulaire du domaine des échangeurs de chaleur pour les composants électroniques. En fait, ces « plaques » ne sont pas nécessairement planes et peuvent avoir toute forme adaptée à leur fonction.

Sur les figures, les corps 110, 210, 310 et 410 sont représentés monobloc, pour la clarté du dessin. En pratique, ils peuvent être constitués de plusieurs parties assemblées ensemble, notamment par vissage.

L'invention est décrite ci-dessus dans le cas où le fluide caloporteur sert au refroidissement d'un composant.

L'invention est représentée sur les figures dans le cas de son utilisation dans le domaine du refroidissement de composants électroniques. Elle peut être utilisée dans d'autres domaines, notamment pour le contrôle en température d'un moule d'injection de pièces en matériau synthétique.

Les caractéristiques des modes de réalisation et variantes mentionnées ci-dessus peuvent être combinées en totalité ou en partie.

Le corps 410 pourrait être monté rotatif par rapport à la plaque 8, de même que le corps 310. Il suffit en effet que les éléments 310 et 400 soient solidaires en translation de leur support respectif selon l'axe X300A, dans le sens des flèches F6 et F8 de manière à ce que les éléments logés dans les éléments 310 et 400 soient également solidaires en translation axiale de leur support dans le sens où leurs configurations dépendent de la position axiale du support commun selon l'axe X300A par rapport à la plaque 2.

**Revendications**

1. Système (S) de refroidissement d'au moins un composant (4) ou une pièce, ce système comprenant :

   - une plaque d'échange thermique (2) qui comprend un conduit (6) de circulation de fluide caloporteur équipé, d'une part, en extrémités d'éléments de raccord (100A, 100B) pourvus chacun d'un obturateur (150) et, d'autre part, d'un dispositif de compensation de volume (200) comprenant un piston (230) monté avec possibilité de coulissement étanche par rapport à la plaque, entre une première position (figure 2) rétractée et une deuxième position (figure 3) avancée par rapport à la position rétractée et dans laquelle le volume disponible pour le fluide caloporteur dans le conduit (6) est augmenté par rapport à son volume dans la première position

- des moyens (8, 82, 84, 300A, 300B) d'alimentation et/ou d'évacuation du conduit en fluide caloporteur, ces moyens comprenant des éléments de raccord (300A, 300B) complémentaires de ceux de la plaque (2) pour le raccordement et la déconnexion du conduit (6) de la plaque (2) avec une source d'alimentation et/ou une ligne d'évacuation de fluide caloporteur **caractérisé en ce qu'**un organe (400) de maintien du piston dans sa position rétractée est solidaire d'au moins un premier élément de raccord (300A) complémentaire d'un premier élément de raccord de la plaque (100A), au moins en translation selon leur axe d'emmanchement (X100A, X300A), et **en ce que** cet organe de maintien est apte à :

- bloquer le piston (230) dans sa première position lorsque le premier élément de raccord de la plaque (100A) et le premier élément de raccord complémentaire (300A) sont accouplés et

- maintenir le piston (230) dans sa première position, lors du désaccouplement du premier élément de raccord de la plaque (100A) et du premier élément de raccord complémentaire (300A), au moins tant que l'obturateur (150) du premier élément de raccord de la plaque n'est pas en position d'obturation d'un conduit interne (130) de cet élément de raccord (100A).

2. Système selon la revendication 1, **caractérisé en ce qu'**un axe de coulissement (X200) du piston (230) entre ses première et deuxième positions est parallèle à un axe d'emmanchement (X100A, X300A) du premier élément de raccord de la plaque (100A) et du premier élément de raccord complémentaire (300A).

3. Système selon l'une des revendications précédentes, **caractérisé en ce que** l'organe de maintien (400) est apte à agir sur au moins un organe (250) de blocage du piston (230) dans sa première position rétractée.

4. Système selon la revendication 3, **caractérisé en ce que** l'organe de maintien (400) est apte à venir en recouvrement de l'organe de blocage (250) pour le blocage du piston (230) dans sa première position rétractée.

5. Système selon l'une des revendications 3 ou 4, **caractérisé en ce que** l'organe de blocage (250) est mobile radialement par rapport à un axe (X200) de coulissement du piston (230), entre une première position de blocage du piston dans sa première position rétractée et une deuxième position de libération du piston.

6. Système selon l'une des revendications 3 à 5, **caractérisé en ce que**, selon un axe de coulissement (X200) du piston (230), dans sa première position, l'organe de blocage (250) solidarise en translation le piston avec un corps (210) du piston, lui-même fixe en translation par rapport à la plaque (2).

7. Système selon l'une des revendications 3 à 6, **caractérisé en ce que** l'organe de blocage (250) est solidaire en translation du piston (230) du dispositif de compensation de volume (200) selon un axe de coulissement (X200) du piston (230).

8. Système selon l'une des revendications 3 à 6, **caractérisé en ce que** le piston (230) est pourvu d'un logement (237) de réception partielle de l'organe de blocage (250) uniquement dans sa première position rétractée.

9. Système selon l'une des revendications 3 à 8, **caractérisé en ce qu'**il comporte plusieurs organes de blocage (250) répartis autour d'un axe central (X200) de coulissement du piston (230).

10. Système selon l'une des revendications précédentes, **caractérisé en ce que** l'organe de maintien (400) comprend un corps principal (410) fixe en translation par rapport à un corps (310) du premier élément de raccord complémentaire (300A), ainsi qu'un corps secondaire (430) mobile en translation par rapport au corps principal fixe, selon une direction (X400) parallèle à l'axe d'emmanchement (X100A, X300A) du premier élément de raccord de la plaque (100A) et du premier élément de raccord complémentaire (300A), **en ce que** le corps secondaire (430) est repoussé élastiquement vers l'avant par rapport au corps principal fixe (410) et **en ce que** le corps secondaire (430) et/ou le corps principal (410) sont aptes à venir en butée contre le piston (230) au moins en configuration accouplée des éléments de raccord.

11. Système selon la revendication 10, **caractérisé en ce que** le corps secondaire (430) est apte à agir sur au moins un organe (250) de blocage du piston (230) dans sa première position.

**12.** Système selon l'une des revendications 10 ou 11 **caractérisé en ce que** le corps principal (410) est pourvu d'une partie (419) d'appui contre le piston (230) en configuration accouplée du premier élément de raccord de la plaque (100A) et du premier élément de raccord complémentaire (300A) et **en ce que** le corps principal (410) est positionné par rapport au premier élément de raccord complémentaire (300A) de telle sorte que, lors de l'accouplement de cet élément de raccord avec le premier élément de raccord de la plaque (100A), le premier élément de raccord de la plaque (100A) et le premier élément de raccord complémentaire (300A) sont amenés en configuration passante, avant que la partie d'appui (419) du corps principal (410) entre en contact avec le piston (230).

**13.** Système selon l'une des revendications 3 à 12, **caractérisé en ce que**, en configuration accouplée du premier élément de raccord de la plaque (100A) et du premier élément de raccord complémentaire (300A), la somme de la longueur de recouvrement (L) sur laquelle l'organe de maintien (400) reste en prise avec l'organe de blocage (250), mesurée parallèlement à un axe d'emmanchement (X100A, X300A) de ces éléments de raccord, et d'un jeu axial (J) entre le corps principal (410) et le corps secondaire (430) est supérieure à la course de fermeture (C) de l'obturateur (150) du premier élément de raccord de la plaque (100A) à partir de la configuration accouplée et parallèlement à l'axe d'emmanchement des éléments de raccord.

**14.** Système selon l'une des revendications précédentes, **caractérisé en ce que** l'organe (400) de maintien est également solidaire d'un second élément de raccord (300B) complémentaire d'un second élément de raccord (100B) de la plaque (2), au moins en translation selon leur axe d'emmanchement (X100B, X300B), et **en ce que** cet organe de maintien (400) est apte à maintenir le piston (230) dans sa première position, lors du désaccouplement des premiers éléments des raccords de la plaque (100A, 100B) et des premiers éléments des raccords complémentaires (300A, 300B), au moins tant que chacun des obturateurs (150) des premiers éléments de raccord (100A, 100B) de la plaque (2) n'est pas en position d'obturation du conduit interne (130) respectif des éléments de raccord (100A, 100B).

**Patentansprüche**

**1.** System (S) zur Kühlung mindestens einer Komponente (4) oder eines Teils, wobei das System umfasst:

- eine Wärmetauscherplatte (2), die einen Kanal (6) für die Zirkulation eines Wärmeträgerfluids aufweist, der einerseits an den Enden mit Anschlusselementen (100A, 100B), die jeweils mit einem Verschlusselement (150) versehen sind, und andererseits mit einer Vorrichtung (200) zur Volumenkompensation ausgerüstet ist, die einen Kolben (230) umfasst, der mit der Möglichkeit des abgedichteten Gleitens in Bezug auf die Platte zwischen einer ersten zurückgezogenen Stellung (Figur 2) und einer zweiten vorgerückten Stellung (Figur 3) in Bezug auf die zurückgezogene Stellung montiert ist, und in der das verfügbare Volumen für das Wärmeträgerfluid in dem Kanal (6) in Bezug auf ihr Volumen in der ersten Stellung vergrößert ist,
- Mittel (8, 82, 84, 300A, 300B) zur Versorgung und/oder Entleerung des Kanals mit und/oder von Wärmeträgerfluid, wobei diese Mittel Anschlusselemente (300A, 300B) umfasst, die komplementär zu denen der Platte (2) sind, für den Anschluss und die Trennung des Kanals (6) der Platte (2) mit bzw. von einer Versorgungsquelle für das Wärmeträgerfluid und/oder einer Entleerungsleitung,
**dadurch gekennzeichnet, dass** ein Element (400) zum Halten des Kolbens in seiner zurückgezogenen Stellung mit mindestens einem ersten, zu einem ersten Anschlusselement der Platte (100A) komplementären Anschlusselement (300A) mindestens in Längsbewegung gemäß ihrer Eingreifachse (X100A, X300A) verbunden ist, und dass dieses Halteelement geeignet ist:
- den Kolben (230) in seiner ersten Stellung zu blockieren, wenn das erste Anschlusselement (100A) der Platte und das erste komplementäre Anschlusselement (300A) verbunden sind, und
- den Kolben (230) in seiner ersten Stellung bei der Trennung des ersten Anschlusselements (100A) der Platte und des ersten komplementären Anschlusselements (300A) zu halten, mindestens solange das Verschlusselement (150) des ersten Anschlusselements der Platte nicht in der Position des Verschlusses eines Innenkanals (130) dieses Anschlusselements (100A) ist.

**2.** System nach Anspruch 1, **dadurch gekennzeichnet, dass** eine Gleitachse (X200) des Kolbens (230) zwischen seiner ersten und zweiten Stellung parallel zu einer Eingreifachse (X100A, X300A) des ersten Anschlusselements der Platte (100A) und des ersten komplementären Anschlusselements (300A) liegt.

**3.** System nach einem der vorhergehenden Ansprüche, **dadurch gekennzeichnet, dass** das Halteelement (400) geeignet ist, auf mindestens ein Blockierelement (250) des Kolbens (230) in seiner ersten zurückgezogenen Stellung zu wirken.

4. System nach Anspruch 3, **dadurch gekennzeichnet, dass** das Halteelement (400) geeignet ist, in Überlappung mit dem Blockierelement (250) für die Blockierung des Kolbens (230) in seiner ersten zurückgezogenen Stellung zu kommen.

5. System nach einem der Ansprüche 3 oder 4, **dadurch gekennzeichnet, dass** das Blockierelement (250) radial in Bezug auf eine Gleitachse (X200) des Kolbens (230) zwischen einer ersten Position des Blockierens des Kolbens in seiner ersten zurückgezogenen Stellung und einer zweiten Position des Freigebens des Kolbens beweglich ist.

6. System nach einem der Ansprüche 3 bis 5, **dadurch gekennzeichnet, dass** das Blockierelement (250) in seiner ersten Stellung den Kolben translatorisch mit einem Körper (210) des Kolbens gemäß einer Gleitachse (X200) des Kolbens (230) verbindet, wobei der Körper selbst translatorisch in Bezug auf die Platte (2) feststehend ist.

7. System nach einem der Ansprüche 3 bis 6, **dadurch gekennzeichnet, dass** das Blockierelement (250) translatorisch mit dem Kolben (230) der Vorrichtung (200) zur Volumenkompensation gemäß einer Gleitachse (X200) des Kolbens (230) verbunden ist.

8. System nach einem der Ansprüche 3 bis 6, **dadurch gekennzeichnet, dass** der Kolben (230) mit einer Aufnahme (237) zum teilweisen Aufnehmen des Blockierelements (250) nur in seiner ersten zurückgezogenen Stellung versehen ist.

9. System nach einem der Ansprüche 3 bis 8, **dadurch gekennzeichnet, dass** es mehrere Blockierelemente (250) aufweist, die um eine Mittelachse (X200) des Gleitens des Kolbens (230) verteilt sind.

10. System nach einem der vorhergehenden Ansprüche, **dadurch gekennzeichnet, dass** das Halteelement (400) einen Hauptkörper (410), der translatorisch in Bezug auf einen Körper (310) des ersten komplementären Anschlusselements (300A) fest ist, sowie einen Nebenkörper (430) umfasst, der translatorisch in Bezug auf den feststehenden Hauptkörper gemäß einer Richtung (X400) parallel zur Eingreifachse (X100A, X300A) des ersten Anschlusselements der Platte (100A) und des ersten komplementären Anschlusselements (300A) der Platte beweglich ist, dass der Nebenkörper (430) elastisch in Bezug auf den feststehenden Hauptkörper (410) nach vorn zurückgestoßen wird und dass der Nebenkörper (430) und/oder der Hauptkörper (410) geeignet sind, in Anschlag gegen den Kolben (230) mindestens in der verbundenen Konfiguration der Anschlusselemente zu kommen.

11. System nach Anspruch 10, **dadurch gekennzeichnet, dass** der Nebenkörper (430) geeignet ist, auf mindestens ein Blockierelement (250) des Kolbens (230) in seiner ersten Stellung zu wirken.

12. System nach einem der Ansprüche 10 oder 11, **dadurch gekennzeichnet, dass** der Hauptkörper (410) mit einem Bereich (419) zur Anlage gegen den Kolben (230) in der verbundenen Konfiguration des ersten Anschlusselements der Platte (100A) und des ersten komplementären Anschlusselements (300A) der Platte versehen ist, und dass der Hauptkörper (410) in Bezug auf das erste komplementäre Anschlusselement (300A) derart positioniert ist, dass bei dem Verbinden dieses Anschlusselements mit dem ersten Anschlusselement der Platte (100A) das erste Anschlusselement der Platte (100A) und das erste komplementäre Anschlusselement (300A) in eine Übergangskonfiguration geführt werden, bevor der Anlagebereich (419) des Hauptkörpers (410) in Kontakt mit dem Kolben (230) tritt.

13. System nach einem der Ansprüche 3 bis 12, **dadurch gekennzeichnet, dass** in der verbundenen Konfiguration des ersten Anschlusselements der Platte (100A) und des ersten komplementären Anschlusselements (300A) die Summe der Länge (L) der Überdeckung, über die das Halteelement im Eingriff mit dem Blockierelement (250) verbleibt, gemessen parallel zu einer Eingreifachse (X100A, X300A) dieser Anschlusselemente, und eines axialen Spiels (J) zwischen dem Hauptkörper (410) und dem Nebenkörper (430) größer ist als der Verschlussweg (C) des Verschlusselements (150) des ersten Anschlusselements der Platte (100A) von der verbundenen Konfiguration und parallel zur Eingriffsachse der Anschlusselemente.

14. System nach einem der vorhergehenden Ansprüche, **dadurch gekennzeichnet, dass** das Halteorgan (400) ebenfalls mit einem zweiten Anschlusselement (300B) komplementär zu einem zweiten Anschlusselement (100B) der Platte (2) mindestens translatorisch gemäß ihrer Eingreifachse (X100B, X300B) verbunden ist, und dass dieses Halteelement (400) geeignet ist, den Kolben (230) in seiner ersten Stellung bei der Trennung der ersten Anschlusselemente der Platte (100A, 100B) und der ersten komplementären Anschlusselemente (300A, 300B) zu halten, mindestens solange jedes der Verschlusselemente (150) der ersten Anschlusselemente (100A, 100B) der Platte (2) nicht in der Position des Verschlusses des jeweiligen Innenkanals (130) der Anschlusselemente (100A, 100B) ist.

## Claims

1. A system (S) for cooling at least one component (4) or part, said system comprising:

    - a heat exchange plate (2) that comprises a coolant circulation duct (6) and that is equipped, on the one hand, at the ends with connector elements (100A, 100B) each provided with a closure member (150) and, on the other hand, a volume compensating device (200) comprising a piston (230) mounted able to slide sealably relative to the plate, between a first retracted position (figure 2) and a second forward position (figure 3) relative to the retracted position in which the volume available for the coolant in the duct (6) is increased relative to its volume in the first position;
    - supply and/or discharge means (8, 82, 84, 300A, 300B) for the cooling duct, said means comprising connecting elements (300A, 300B) complementary to those of the plate (2) for the connection and disconnection of the duct (6) of the plate (2) with a supply source and/or a coolant discharge line;
    **characterized in that** a member (400) for keeping the piston in its retracted position is secured to at least a first complementary connector element (300A) of a first connector element of the plate (100A), at least in translation along the fitting axis (X100A, X300A) thereof, and **in that** this maintaining member is capable of:
    - locking the piston (230) in its first position when the first connector element of the plate (100A) and the first complementary connector element (300A) are coupled, and
    - keeping the piston (230) in its first position, during the separation of the first connector element of the plate (100A) and the first complementary connector element (300A), at least as long as the closure member (150) of the first connector element of the plate is not in the position closing off an inner duct (130) of that connector element (100A).

2. The system according to claim 1, **characterized in that** a sliding axis (X200) of the piston (230) between its first and second positions is parallel to a fitting axis (X100A, X300A) of the first connector element of the plate (100A) and the first complementary connecting element (300A).

3. The system according to one of the preceding claims, **characterized in that** the maintaining member (400) can act on at least one member (250) for locking the piston (230) in its first retracted position.

4. The system according to claim 3, **characterized in that** the maintaining member (400) can cover the locking member (250) to lock the piston (230) in its first retracted position.

5. The system according to one of claims 3 or 4, **characterized in that** the locking member (250) is radially movable relative to the sliding axis (X200) of the piston (230), between a first position locking the piston in its first retracted position and a second position releasing the piston.

6. The system according to one of claims 3 to 5, **characterized in that**, along a sliding axis (X200) of the piston (230), in its first position, the locking member (250) secures the piston in translation with the body (210) of the piston, which in turn is fixed in translation relative to the plate (2).

7. The system according to one of claims 3 to 6, **characterized in that** the locking member (250) is secured in translation to the piston (230) of the volume compensation device (200) along a sliding axis (X200) of the piston (230).

8. The system according to one of claims 3 to 6, **characterized in that** the piston (230) is provided with a housing (237) for partially receiving the locking member (250) only in the first retracted position thereof.

9. The system according to one of claims 3 to 8, **characterized in that** it includes several locking members (250) distributed around a central sliding axis (X200) of the piston (230).

10. The system according to one of the preceding claims, **characterized in that** the maintaining member (400) comprises a primary body (410) fixed in translation relative to a body (310) of the first complementary connector element (300A), as well as a secondary body (430) translatably movable relative to the fixed primary body, in a direction (X400) parallel to a fitting axis (X100A, X300A) of the first connector element of the plate (100A) and the first complementary connector element (300A), **in that** the secondary body (430) is elastically pushed forward relative to the fixed primary body (410) and **in that** the secondary body (430) and/or the primary body (410) can abut against the piston (230) at least in the coupled configuration of the connector elements.

11. The system according to claim 10, **characterized in that** the secondary body (430) can act on at least one locking member (250) for locking the piston (230) in its first position.

12. The system according to one of claims 10 or 11, **characterized in that** the primary body (410) is provided with at least one bearing portion (419) bearing against the piston (230) in the coupled configuration of the first connector element of the plate (100A) and the first complementary connector element (300A) and **in that** the primary body (410) is positioned relative to the first complementary connector element (300A) such that, during the coupling of that connector element with the first connector element of the plate (100A), the first element of the connector of the plate (100A) and the first complementary connector element (300A) are brought into the open configuration, before the bearing part (419) of the primary body (410) comes into contact with the piston (230).

13. The system according to one of claims 3 to 12, **characterized in that**, in the coupled configuration of the first connector element of the plate (100A) and the first complementary connector element (300A), the sum of the covering the length (L) over which the maintaining member (400) remains engaged with the locking member (250), measured parallel to a fitting axis (X100A, X300A) of said connector elements, and an axial play (J) between the primary body (410) and the secondary body (430) is greater than the closing travel (C) of the closure member (150) of the first connector element of the plate (100A) from the coupled configuration and parallel to the fitting axis of the connector elements.

14. The system according to one of the preceding claims, **characterized in that** the maintaining member (400) is also secured to a second complementary connector element (300B) of a second connector element (100B) of the plate (2), at least in translation along their fitting axis (X100B, X300B), and **in that** that maintaining member (400) can keep the piston (230) in its first position, during the separation of the first elements of the connectors of the plate (100A, 100B) and the first elements of the complementary connectors (300A, 300B), at least as long as each of the closure members (150) of the first connector elements (100A, 100B) of the plate (2) is not in the position closing off the respective inner duct (130) of the connector elements (100A, 100B).

**Fig. 1**

Fig. 2

Fig. 3

Fig. 4

EP 2 623 916 B1

Fig. 5

**Fig. 6**

Fig. 7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1790458 A